# EUROPÄISCHE PATENTSCHRIFT

(11) **EP 1 639 869 B1**
(45) Veröffentlichungstag und Bekanntmachung des Hinweises auf die Patenterteilung: **18.04.2007**
(21) Anmeldenummer: 04729604.1
(22) Anmeldetag: 27.04.2004
(51) Int. Cl.: H05K 1/02

(54) **LEITERPLATTE**
PRINTED CIRCUIT BOARD
CARTE DE CIRCUITS IMPRIMES

(30) Priorität: 23.06.2003 DE 10328285
(43) Veröffentlichungstag der Anmeldung: 29.03.2006
(73) Patentinhaber: Korstens & Goossens GmbH, 42781 Haan (DE)
(72) Erfinder: GRÜTER, Ernst-Christoph, 46514 Scharmbeck (DE)
(74) Vertreter: Bungartz, Klaus Peter
(86) Internationale Anmeldenummer: PCT/DE2004/000885
(87) Internationale Veröffentlichungsnummer: WO 2005/002300

(56) Entgegenhaltungen:
- WO-A-03/077313
- DE-A- 10 134 143
- JP-A- 2002 159 119
- US-A- 5 358 774
- US-B1- 6 295 199

## Beschreibung

Die Erfindung betrifft eine Leiterplatte mit zumindest einer nicht leitenden Trägerplatte, die einseitig oder beidseitig mit elektrischen Bauelementen und Leiterbahnen zur elektrischen Kontaktierung der Bauelemente versehen ist, mit zumindest einer Niederstromschaltungsanordnung zur Einkopplung und bzw. oder Übertragung niedriger Stromleistungen und mit zumindest einer Hochstromschaltungsanordnung zur Einkopplung und/oder Übertragung hoher Stromleistungen, wobei die Niederstromschaltungsanordnung Leiterbahnen umfasst, die zumindest teilweise eine Dicke von 100µm oder weniger aufweisen und die Hochstromschaltungsanordnung zumindest einem Kontaktblock (5) zur Stromeinkopplung und Leiterbahnen mit einer Dicke von 500µm oder mehr aufweisen.

Leiterplatten dieser Art sind allgemein bekannt. Sie weisen meist einen im Vergleich zur Hochstromschaltungsanordnung größeren Bereich einer Niederstromschaltungsanordnung auf, der elektrisch mit der Hochstromschaltungsanordnung in Verbindung steht. Die Leiterbahnen der Niederstromschaltungsanordnung werden dabei meist in Ätztechnik hergestellt, wobei zunächst das leitende Material flächig auf ein als Trägerplatte eingesetztes Substrat aufgebracht wird, dass anschließend partiell weggeätzt wird, so dass sich das gewünschte Leitungsmuster ergibt. Auf diese Leitungen werden dann die jeweiligen elektrischen Bauelemente aufgesetzt. Alternativ können die Leiterbahnen auch auf die Trägerplatte aufgedruckt werden.

Weiterhin ist aus der JP2002 159119 A eine Leiterplatte bekannt, bei der die Hochstromeingangsleitung getrennt von den Niederstromkreisen auf gegenüberliegenden Seiten der Leiterplatten vorgesehen sind. Bei dieser Leiterplatte sind allerdings die Bauelemente der Hochstromschaltungsanordnung auf die Leiterplatte selbst aufgesetzt, so dass die Hochstromschaltungsanordnung als räumlich von der Niederstromschaltungsanordnung getrennte Anordnung auf die Leiterplatte komplett mit ihren Bauelementen aufgesetzt ist. Mit dieser Anordnung ist kein Aufbau einer einen Hochstrombereich und einen Niederstrombereich aufweisenden Leiterplatte, insbesondere im Sandwich-Verfahren möglich.

Üblicherweise werden heute zumindest beide Seiten der Trägerplatte mit einem Leitungsmuster versehen. Um die jeweiligen Seiten miteinander zu verbinden werden hier Durchgangsbohrungen verwendet, über die beide Ebenen miteinander kontaktiert werden. Moderne Leiterplatten weisen schließlich als so genannte Multilayer-Platten mehrere, übereinander angeordnete nicht leitende Trägerplatten auf, die jeweils beidseitig mit einem Leiterbild versehen sind. Hier sind die gegenüberliegenden Leiterbahnen benachbarter Trägerplatten mit einer elektrischen Isolationsschicht versehen, die üblicherweise durch Auftragen eines Isolationslackes hergestellt wird.

Je nach Anwendungsgebiet können die elektrischen Leistungen, die über die Leiterbahnen übertragen werden, sehr unterschiedlich sein. Grundsätzlich muss die Leiterbahn auf die Leistung abgestimmt sein, um unerwünschte Hitzeentwicklungen durch zu große elektrische Widerstände zu vermeiden. Im einfachsten Fall wird einer Hitzeentwicklung durch eine breitere Leiterbahn vermieden, was natürlich zu einem größeren Platzbedarf führt, der gerade in modernen, hoch integrierten Geräte nicht tolerabel ist.

Zu Vermeidung dieses Nachteils weisen die bekannten Leiterbahnen neben der Niederstromschaltungsanordnung mit den üblichen Leiterbahnen in bekannter Dicke von 100µm oder weniger die Hochstromschaltungsanordnung mit Leiterbahnen und Kontaktieranschlüssen von mehr 300 bis 400µm auf. Diese dickeren Leiterbahnen werden üblicherweise ebenfalls in Ätztechnik aus Kupferfolien mit einer Dicke von bis zu 300 bis 400µm hergestellt, die optional einem galvanischen Aufbau zur weiteren Erhöhung der Querschnitte unterzogen werden können.

Obwohl bei den bekannten Leiterbahnen die Erwärmung infolge des elektrischen Widerstandes wirksam vermieden werden kann, weisen sie immer noch den Nachteil eines zu großen Raumbedarfes auf. Zwar wird jetzt die benötigte Fläche der Trägerplatte nicht mehr durch eine Verbreiterung der Leiterbahnen erhöht, jedoch wird dieser Vorteil durch eine höhere Bauhöhe der einzelnen Leiterplatten erkauft.

Gerade im Zusammenhang mit der Multilayer-Technik ergibt sich hiermit das Problem, dass über der Hochstromschaltungsanordnung angeordnete weitere Schichten mit den zum Beispiel in Kupfertechnik hergestellten Hochstromleitern kollidieren, da diese nicht mehr in der Leiterplatte integriert ist. Dies würde zu hohen Plattenstapeln mit Hohlräumen führen, was bei Herstellung solcher Baugruppen aus mechanischen Gründen und wegen des erhöhten Raumbedarfes nicht erwünscht ist.

Das ebenfalls bekannte Absenken der dicken Kupferleiter in die Trägerplatte durch Erwärmen und Aufbringen mechanischer Energie führt ebenfalls nicht zu einer ausreichend hohen Integration der Hochstromschaltungsanordnung. Neben der Problematik, dass die Trägerplatte mechanisch verformt werden muss, werden auch hier Hohlräume erzeugt, die zu Störungen führen können und den Aufbau eines einheitlichen Plattenstapels erschweren.

Darüber hinaus sind im Stand der Technik so genannte Metallkernplatten allgemein bekannt, bei denen sich die Hochstromschaltungsanordnung durch die gesamte Leiterplatte erstreckt. Diese haben jedoch den Nachteil, dass durch den Metallkern ein Durchkontaktieren erschwert ist, das Gewicht der Leiterplatte erhöht ist und die Herstellungskosten bei individuell an das Gehäuse angepassten Plattengeometrien und kleinen Serien erhöht sind.

Aufgabe der Erfindung ist es daher, eine Leiterplatte zu schaffen, die bei möglichst geringer Baugröße und eine möglichst hohe Integration der Hochstromschaltungsanordnung ermöglicht.

Diese Aufgabe wird nach der Erfindung dadurch gelöst, dass die Hochstromschaltungsanordnung nur in einem Teil der Leiterplatte angeordnet ist und zur Aufnahme der Leiterbahnen und bzw. oder des Kontaktblocks der Hochstromschaltungsanordnung die Trägerplatte wenigstens eine Bauelementaufnahme in Form einer taschenartigen oder durchgängigen Ausnehmung aufweist, in die die Leiterbahnen und bzw. oder der Kontaktblock der Hochstromschaltungsanordnung eingesetzt ist.

Durch die erfindungsgemäße Ausgestaltung der Leiterplatte können nun im Rahmen der Gesamtdicke der Leiterplatte beliebige Leiterdicken vorgesehen werden. Zur Integration größerer Leiterstärken wird die Bauelementaufnahme in die Trägerplatte eingebracht, wobei dies bevorzugt durch Fräsen erfolgt. Die Bauelementaufnahme kann aber auch unmittelbar beim Herstellungsprozess der üblicherweise aus Kunststoff gefertigten Trägerplatte hergestellt werden, indem die Ausnehmung bereits bei der Formgebung berücksichtigt wird.

Im einfachsten Fall weist eine erfindungsgemäße Leiterbahn nur eine Trägerplatte auf. Hier besteht die Bauelementaufnahme aus einer Tasche, die in eine der Breitseiten der Trägerplatte eingebracht ist. In diese Tasche, die auch die Form beliebiger Kanalstrukturen haben kann, wird nun ein Leiter mit großer Stärke, insbesondere Kupferleitungen oder ein Anschlussblock aus Kupfer eingelegt.

Anstelle des Kupfers kann selbstverständlich auch jedes andere leitfähige Material benutzt werden. Diese Leitungen oder Anschlussblöcke der Hochstromschaltungsanordnung weisen zum Beispiel eine Dicke von mehr als 500µm auf und können, sofern der Stapel der Trägerplatten ausreichend hoch ist, eine nahezu beliebige Dicke aufweisen. Bevorzugt wird die Dicke jedoch zwischen 500µm und 1200µm liegen, bei einer noch weiter bevorzugten Ausgestaltung werden derzeit Dicken von 500µm bis 600µm eingesetzt, obwohl die Anwendung der Erfindung nicht auf diese Leiterstärken beschränkt ist.

Die Trägerplatte wird meist als dünnes Flächenelement mit zwei Breitseiten und einer umlaufenden Schmalseite ausgebildet sein. Üblicherweise sind solche Platten rechteckig oder an die Gehäuseform des aufnehmenden Gehäuses angepasst. Als Material wird meist ein vernetzter oder nicht vernetzter Kunststoff eingesetzt, der meist durch eingelegte Glas- oder Kohlefasern bzw. Abschnitte solcher Fasern verstärkt ist.

Die Bauelementaufnahme kann an einer der Außenseiten der Leiterplatte im Bereich der Breitseite oder der Schmalseite der Trägerplatte angeordnet sein, alternativ kann auch eine Anordnung an einer Ecke der Trägerplatte vorgesehen sein. Die in der Bauelementaufnahme angeordneten Leiterbahnen und eventuelle Kontaktblöcke zur Einkopplung von Strömen hoher Leistung sind dann bevorzugt vollständig versenkt angeordnet, das heißt sie ragen nicht aus der Fläche der Breitseite und der Schmalseite bzw. im Falle einer Eckanordnung aus beiden Seiten heraus.

Kontaktblöcke werden bei den erfindungsgemäßen Leiterplatten vorgesehen, um eine externe Stromquelle höherer Leistung mit der Leiterplatte zu kontaktieren. Über diesen Kontaktblöcken können Lufträume vorgesehen sein, die bewusst zum Aufstecken üblicher Kontaktierungsmittel freigelassen werden. Dies können beispielsweise Steckerleisten oder Anschlüsse für standardisierte Bussysteme sein.

Die die Bauelementaufnahme bildende Ausnehmung kann als durchgängige Ausnehmung oder auch als Tasche bzw. Kanal ausgebildet sein. Durchgängige Ausnehmungen können bereits beim Herstellungsprozess in die Trägerplatte eingebracht werden oder sie werden durch Stanzen bzw. herkömmliche Schneidverfahren nachträglich eingebracht. Bevorzugt werden die Bauelementaufnahmen auch durch Fräsen hergestellt.

Durchgängige Bauelementaufnahmen werden bevorzugt in Verbindung mit der Multilayer-Technik für die inneren Trägerplatten eingesetzt. Hier können mehrere übereinander angeordnete Trägerplatten jeweils an gleicher Position angeordnete Ausnehmungen aufweisen, die dann zusammen die Bauelementaufnahmen bilden. Die obere Trägerplatte kann dann geschlossen ausgebildet sein, wobei auch bei dieser Platte eine Ausnehmung und der Unterseite angeordnet sein kann. Gleiches gilt für die untere Trägerplatte. Alternativ kann die Ausnehmung auch in den Randplatten durchgängig ausgebildet sein, so dass sich die Bauelementaufnahmen bis an die äußere Fläche der Leiterplatte erstreckt, wo sie zum Beispiel unmittelbar kontaktiert werden kann.

Kontaktblöcke zum Einbringen einer hohen Leistung werden jedoch bei einer weiteren Ausgestaltung der Erfindung auch an der Schmalseite der Leiterplatte angeordnet. Hier kann dann seitlich über die üblichen Kontaktmittel eine Kontaktierung erfolgen. Dies hat den Vorteil, dass durch die Anschlüsse die Bauhöhe nicht erhöht wird. Hierzu erstreckt sich entweder der Kontaktblock bis an den Rand, so dass er selbst unmittelbar kontaktierbar ist oder eine Kupferleitung ist, vom inneren Kontaktblock kommend, bis an den Rand herangeführt, wo sie etwa in Buchsen oder Steckern endet.

Alternativ zu einer durchgängigen Bauelementaufnahme kann diese auch als einseitig offene Tasche in einer der der Breitseiten und/oder in der Schmalseite ausgebildet sein. Dies kann bereits im einfachsten Fall ausreichen, um einen dickere Leiterbahn zu realisieren. Reicht dies nicht aus, können entweder zwei Taschen einander zugewandt in benachbarten Trägerplatten an gleichen Positionen vorgesehen sein oder eine Ausnehmung wird durchgängig durch eine oder mehrere Trägerplatten ausgeführt.

Üblicherweise wird die Leiterplatte mehrere Bauelementaufnahmen aufweisen. So kann zum Beispiel eine Bauelementaufnahme zur Kontaktierung mit einer externen Stromversorgung vorgesehen sein. Ausgehend hiervon kann dann die Hochstromschaltung mehrere Leiterbahnen einer größeren Stärke umfassen, die in kanalartigen Bauelementaufnahmen angeordnet werden können. Auch weitere Kupferblöcke können je nach Erfordernis des Elektroniklayouts vorgesehen sein. Die kanalartigen Leiterbahnen können dabei die Leiterplatte parallel zur Breitseite oder auch senkrecht hierzu durchsetzen.

Die Leiterbahnen und die Kontaktblöcke der Hochstromschaltungsanordnung können auf beliebige Weise mit der Leiterplatte verbunden sein. In einigen Fällen wird bereits die Kontaktierung eine ausreichende Verbindung gewährleisten. Dies wird insbesondere dann gegeben sein, wenn über der Bauelementaufnahme weitere Trägerplatten angeordnet sind, die keine Ausnehmung aufweisen. Ist dies nicht der Fall, können in die Bauelementaufnahme auch Leiter oder Kontaktblöcke eingeklemmt oder -geklebt werden.

Weitere Merkmale und Vorteile der Erfindung ergeben sich aus den Unteransprüchen und aus der nachfolgenden Beschreibung bevorzugter Ausführungsbeispiele anhand der Zeichnungen.

In den Zeichnungen zeigt:
- Fig. 1: eine erste Ausgestaltung einer erfindungsgemäßen Leiterplatte und
- Fig. 2: eine weitere Ausgestaltung einer Leiterplatte.

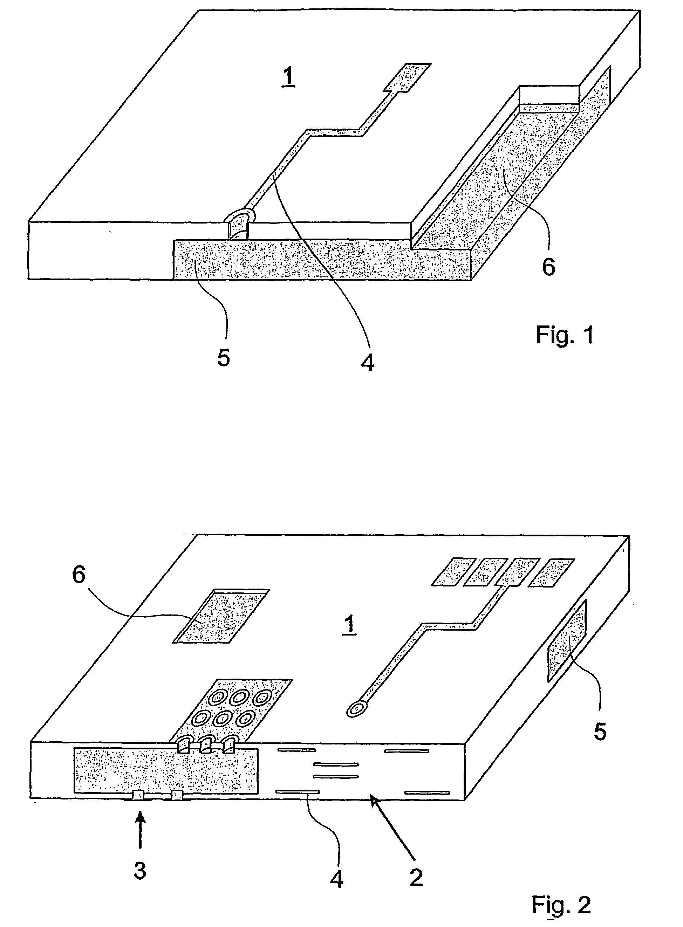

In Figur 1 ist eine Leiterplatte mit einer Trägerplatte 1 dargestellt. Diese Trägerplatte 1 ist mit einer Niederstromschaltungsanordnung 2 und einer Hochstromschaltungsanordnung 3 versehen, wobei in letzterer Ströme höherer Leistung verarbeitet werden können, um etwa zum Aufbau elektronischer Regelungen den Steuerstrom nicht herunter transformieren zu müssen.

Die Leiterplatte west einen aus Kupfer gefertigten Kontaktblock 5 auf, der in eine an der vorderen rechte Ecke der Trägerplatte 1 angeordnete Bauelementaufnahme 6 eingesetzt ist. Eine weitere Bauelementaufnahme 6 durchsetzt die Trägerplatte 1 im mittleren Bereich, diese Bauelementaufnahme 6 nimmt eine elektrische Leiterbahn 4 auf, die den ersten Kontaktblock 5 mit einem zweiten Kontaktblock 5 verbindet. Im Bereich des vorderen Randes der Trägerplatte 1 ist die Leiterbahn 4 über eine Durchkontaktierung elektrisch mit dem Kontaktblock verbunden. Bei der Leiterbahn 4 handelt es sich ebenfalls um eine Kupfereinlage, die vollständig in die Trägerplatte 1 versenkt ist.

Figur 2 zeigt eine weitere Ausgestaltung der Erfindung, die in Multilayer-Technik ausgebildet ist. Hier sind Bauelementaufnahmen 6 in den mittleren Trägerplatten 1 als miteinander deckungsgleiche, durchgängige Ausnehmungen vorgesehen, die Kontaktblöcke 5 aufnehmen, deren Dicke fast der Dicke der gesamten Leiterplatte entspricht. Auch hier sind mehrere Kontaktblöcke 5 vorgesehen, wobei diese teilweise bündig mit den Schmalseiten und teilweise bündig mit den Breitseiten der Leiterplatten abschließen.

Neben der von diesen Bauteilen gebildeten Hochstromschaltungsanordnung 3 ist eine aus konventionellen Leiterbahnen 4 gebildete Niederstromschaltungsanordnung 2 vorgesehen.

Im Gegensatz zur bekannten Metallkernplatte durchsetzt hier die Hochstromschaltungsanordnung 3 nicht die gesamte Leiterplatte sondern nur einen Teil hiervon, während der verbleibende Bereich der Niederstromschaltungsanordnung 2 vorbehalten bleibt. Die Hochstromschaltungsanordnung 3 kann sowohl in Querrichtung als auch in Längsrichtung von einem Rand der Leiterplatte zum gegenüberliegenden Rand angeordnet sein oder auch nur bis zu einem mittleren Bereich der Leiterplatte verlaufen.

### Bezugszeichenliste:

- 1: Trägerplatte
- 2: Niederstromschaltungsanordnung
- 3: Hochstromschaltungsanordnung
- 4: Leiterbahnen
- 5: Kontaktblock
- 6: Bauelementaufnahme

## Patentansprüche

1. Leiterplatte mit
• zumindest einer nicht leitenden Trägerplatte (1), die einseitig oder beidseitig mit elektrischen Bauelementen und Leiterbahnen zur elektrischen Kontaktierung der Bauelemente versehen ist,
• zumindest einer Niederstromschaltungsanordnung (2) zur Einkopplung und/oder Übertragung niedriger Stromleistungen und
• zumindest einer Hochstromschaltungsanordnung (3) zur Einkopplung und/oder Übertragung hoher Stromleistungen, wobei
die Niederstromschaltungsanordnung (2) Leiterbahnen umfasst, die zumindest teilweise eine Dicke von 100µm oder weniger aufweisen und die Hochstromschaltungsanordnung (3) zumindest einen Kontaktblock (5) zur Stromeinkopplung und Leiterbahnen (4) mit einer Dicke von 500µm oder mehr aufweist, **dadurch gekennzeichnet, dass**
die Hochstromschaltungsanordnung nur in einem Teil der Leiterplatte angeordnet ist und zur Aufnahme der Leiterbahnen (4) und/oder des Kontaktblocks (5) der Hochstromschaltungsanordnung (3) die Trägerplatte (1) wenigstens eine Bauelementaufnahme (6) in Form einer taschenartigen oder durchgängigen Ausnehmung aufweist, in die die Leiterbahnen (4) und/oder der Kontaktblock (5) der Hochstromschaltungsanordnung (3) eingesetzt ist.

2. Leiterplatte nach Anspruch 1, **dadurch gekennzeichnet, dass** die Trägerplatte (1) als dünnes Flächenelement mit zwei Breitseiten und einer umlaufenden Schmalseite ausgebildet ist, die Bauelementaufnahme (6) an einer der Außenseiten der Leiterplatte im Bereich der Breitseite und/oder der Schmalseite der Trägerplatte (1) angeordnet ist und die in die Bauelementaufnahme (6) eingesetzten Leiterbahnen (4) und/oder der darin eingesetzte Kontaktblock (5) nicht aus der Fläche der Breitseite und/oder der Schmalseite herausragt, insbesondere der Fläche der Breitseite und/oder der Schmalseite eine Ebene bildet.

3. Leiterplatte nach Anspruch 1 oder 2, **dadurch gekennzeichnet, dass** die Bauelementaufnahme (6) als durch die Trägerplatte (1) durchgängige Ausnehmung am Rand oder im inneren Bereich der Trägerplatte (1) ausgebildet ist.

4. Leiterplatte nach einem der vorhergehenden Ansprüche, **dadurch gekennzeichnet, dass** die Bauelementaufnahme (6) als einseitig offene Tasche in einer der der Breitseiten und/oder in der Schmalseite ausgebildet ist.

5. Leiterplatte nach dem vorhergehenden Anspruch, **dadurch gekennzeichnet, dass** die die Bauelementaufnahme (6) aufweisende Trägerplatten (1) im Bereich der Tasche wenigstens eine Bohrung mit eingebrachtem Kontaktmittel aufweist, über das Leiterbahnen, elektrische Bauelemente oder weitere Bauelementaufnahmen (6) mit den in der Bauelementaufnahme (6) angeordneten Leiterbahnen (4) und/oder dem in der Bauelementaufnahme (6) angeordneten Kontaktblock (5) der Hochstromschaltungsanordnung (3) kontaktiert sind.

6. Leiterplatte nach einem der vorhergehenden Ansprüche, **dadurch gekennzeichnet, dass** sie als Multilayer-Platte mit einer Mehrzahl von Trägerplatten (1) ausgebildet und zumindest in einer äußeren Trägerplatte (1) eine Bauelementaufnahme (6) angeordnet ist.

7. Leiterplatte nach einem der vorhergehenden Ansprüche, **dadurch gekennzeichnet, dass** sie als Multilayer-Platte mit einer Mehrzahl von Trägerplatten (1) ausgebildet und zumindest in einer inneren Trägerplatte (1) eine Bauelementaufnahme (6) angeordnet ist.

8. Leiterplatte nach einem der vorhergehenden Ansprüche, **dadurch gekennzeichnet, dass** wenigstens zwei übereinander angeordnete Trägerplatten (1) vorgesehen sind, wobei zumindest eine Bauelementaufnahme (6) von zwei oder mehr übereinander liegenden Ausnehmungen gebildet ist, so dass sich die Bauelementaufnahme (6) über zwei oder mehr Trägerplatten (1) erstreckt.

9. Leiterplatte nach einem der vorhergehenden Ansprüche, **dadurch gekennzeichnet, dass** die Bauelementaufnahme (6) in die Trägerplatte (1) eingefräst ist.

10. Leiterplatte nach einem der vorhergehenden Ansprüche, **dadurch gekennzeichnet, dass** die Leiterbahnen (4) und/oder der Kontaktblock (5) der Hochstromschaltungsanordnung (3) von einem oder mehreren, in die Bauelementaufnahme (6) eingesetzten Kupferblöcken gebildet sind.

11. Leiterplatte nach einem der vorhergehenden Ansprüche, **dadurch gekennzeichnet, dass** die Leiterbahnen (4) und/oder der Kontaktblock (5) der Hochstromschaltungsanordnung (3) eine Dicke von 500 bis 1200 µm aufweisen.

12. Leiterplatte nach dem vorhergehenden Anspruch, **dadurch gekennzeichnet, dass** die Leiterbahnen (4) und/oder der Kontaktblock (5) der Hochstromschaltungsanordnung (3) eine Dicke von 500 bis 600 µm aufweist.

13. Leiterplatte nach einem der vorhergehenden Ansprüche, **dadurch gekennzeichnet, dass** die Leiterbahnen (4) und/oder der Kontaktblock (5) der Hochstromschaltungsanordnung (3) in die Bauelementaufnahme (6) eingeklebt ist.

## Claims

1. A printed circuit board comprising
- at least one non-conducting support plate (1) being provided with electrical components and strip conductors on one side or on both sides for electrically contacting the components,
- at least one low current circuit configuration (2) for coupling and/or transmitting low current capacities and
- at least one high current circuit configuration (3) for coupling and/or transmitting high current capacities, wherein
the low current circuit configuration (2) comprises strip conductors at least partially encompassing a thickness of 100 µm or less and the high current circuit configuration (3) encompassing at least one contact block (5) for the current coupling and strip conductors (4) with a thickness of 500 µm or more, **characterized in that**
the high current circuit configuration is disposed in only one part of the printed circuit board and **in that** the support plate (1) encompasses at least one component receptacle (6) in the form of a pocket-shaped or continuous recess for receiving the strip conductors (4) and/or the contact block (5), the strip conductors (4) and/or the contact block (5) of the high current circuit configuration (3) being inserted into said component receptacle (6).

2. The printed circuit board according to claim 1, **characterized in that** the support plate (1) is configured as a thin flat element comprising two broadsides and a peripheral narrow side, the component receptacle (6) being disposed on one of the outer sides of the printed circuit board in the region of the broadside and/or of the narrow side of the support plate (1) and the strip conductors (4), which are inserted into the component receptacle (6) and/or the contact block (5) inserted therein do not protrude from the surface of the broadside and/or of the narrow side, in particular the surface of the broadside and/or of the narrow side forming a plane.

3. The printed circuit board according to claim 1 or 2, **characterized in that** the component receptacle (6) is configured as a recess being continuous through the support plate (1) at the edge or in the inner region of the support plate (1).

4. The printed circuit board according to one of the preceding claims, **characterized in that** the component receptacle (6) is configured as a pocket being open on one side in one of the broadsides and/or in the narrow side.

5. The printed circuit board according to the preceding claim, **characterized in that** the support plates (1), which encompass the component receptacle (6) encompasses, in the region of the pocket, at least one bore with an inserted contact means via which strip conductors, electrical components or further component receptacles (6) are contacted by means of the strip conductors (4) disposed in the component receptacle (6) and/or the contact block (5) of the high current circuit configuration (3) disposed in the component receptacle (6).

6. The printed circuit board according to one of the preceding claims, **characterized in that** it is configured as a multilayer plate comprising a plurality of support plates (1) and **in that** a component receptacle (6) is disposed at least in an outer support plate (1).

7. The printed circuit board according to one of the preceding claims, **characterized in that** it is configured as a multilayer plate comprising a plurality of support plates (1) and **in that** a component receptacle (6) is disposed at least in an inner support plate (1).

8. The printed circuit board according to one of the preceding claims, **characterized in that** provision is made for at least two support plates (1) being disposed on top of one another, with at least one component receptacle (6) being formed by two or more recesses located on top of one another so that the component receptacle (6) stretches across two or more support plates (1).

9. The printed circuit board according to one of the preceding claims, **characterized in that** the component receptacle (6) is milled into the support plate (1).

10. The printed circuit board according to one of the preceding claims, **characterized in that** the strip conductors (4) and/or the contact block (5) of the high current circuit configuration (3) are formed by one or more copper blocks inserted into the component receptacle (6).

11. The printed circuit board according to one of the preceding claims, **characterized in that** the strip conductors (4) and/or the contact block (5) of the high current circuit configuration (3) encompass a thickness of from 500 to 1200 µm.

12. The printed circuit board according to the preceding claim, **characterized in that** the strip conductors (4) and/or the contact block (5) of the high current circuit configuration (3) encompasses a thickness of from 500 to 600 µm.

13. The printed circuit board according to one of the preceding claims, **characterized in that** the strip conductors (4) and/or the contact block (5) of the high current circuit configuration (3) are glued into the component receptacle (6).

## Revendications

1. Carte de circuits imprimés, avec
- au moins une plaque support (1) non conductrice, qui est munie d'un côté ou des deux côtés d'éléments électriques et de réseaux de circuits imprimés, pour la mise en contact électrique des éléments,
- au moins un agencement de circuits basse tension (2) pour l'injection et/ou la transmission de basses puissances électriques et
- au moins un agencement de circuits haute tension (3) pour l'injection et/ou la transmission de hautes puissances électriques,
l'agencement de basse tension (2) comprenant des réseaux de circuits imprimés, présentant au moins partiellement une épaisseur de 100 µm ou moins et l'agencement de circuits haute tension (3) présentant un bloc de contact (5) pour l'injection de courant et des réseaux de circuits imprimés (4) d'une épaisseur de 500 µm ou plus, **caractérisée en ce que**
l'agencement de circuits haute tension n'est disposé que dans une partie de la carte de circuits imprimés et **en ce que** pour réceptionner les réseaux de circuits imprimés (4) et/ou le bloc de contact (5) de l'agencement de circuits haute tension (3), la plaque support (1) comporte au moins un logement pour éléments (6) sous forme d'un évidement en forme de poche ou d'un évidement continu, dans lequel sont insérés les réseaux de circuits imprimés (4) et/ou le bloc de contact (5) de l'agencement de circuits haute tension (3)

2. Carte de circuits imprimés selon la revendication 1, **caractérisée en ce que** la plaque support (1) est conçue sous la forme d'un élément plan mince, avec deux côtés larges et un côté étroit périphérique, **en ce que** le logement pour éléments (6) est disposé sur l'un des côtés extérieurs de la plaque de circuits imprimés, dans la zone du côté large et/ou du côté étroit de la plaque support (1) et **en ce que** les réseaux de circuits imprimés (4) insérés dans le logement pour éléments (6) et/ou le bloc de contact (5) qui y est inséré ne sailli (ssen) t pas hors de la surface du côté large et/ou du côté étroit, la surface du côté large et/ou du côté étroit formant notamment un plan.

3. Carte de circuits imprimés selon la revendication 1 ou 2, **caractérisée en ce que** le logement pour éléments (6) est conçu sous la forme d'un évidement continu à travers la plaque support (1), sur le bord ou dans la zone intérieure de la plaque support (1).

4. Carte de circuits imprimés selon l'une quelconque des revendications précédentes, **caractérisée en ce que** le logement pour éléments (6) est conçu sous la forme d'une poche ouverte sur un côté dans l'un des côtés larges et/ou dans le côté étroit.

5. Carte de circuits imprimés selon la revendication précédente, **caractérisée en ce que** dans la zone de la poche, les plaques supports (1) comportant le logement pour éléments (6) comportent au moins un perçage avec un moyen de contact inséré, par l'intermédiaire duquel des réseaux de circuits imprimés, des éléments électriques ou d'autres logement pour éléments (6) sont mis en contact avec les réseaux de circuits imprimés (4) disposés dans le logement pour éléments (6) et/ou avec le bloc de contact (5) de l'agencement de circuit haute tension (3) disposé dans le logement pour éléments (6).

6. Carte de circuits imprimés selon l'une quelconque des revendications précédentes, **caractérisée en ce qu'**elle est conçue sous la forme d'une plaque multicouches avec une pluralité de plaques supports (1) et **en ce que** au moins dans une plaque support (1) extérieure est disposé un logement pour éléments (6).

7. Carte de circuits imprimés selon l'une quelconque des revendications précédentes, **caractérisée en ce qu'**elle est conçue sous la forme d'une plaque multicouches avec une pluralité de plaques supports (1) et **en ce que** au moins dans une plaque support (1) intérieure est disposé un logement pour éléments (6).

8. Carte de circuits imprimés selon l'une quelconque des revendications précédentes, **caractérisée que**, au moins deux plaques supports (1) superposées sont prévues, au moins un logement pour éléments (6) étant formé par deux ou par plusieurs évidements, pour que le logement pour éléments (6) s'étende sur deux ou sur plusieurs plaques supports (1).

9. Carte de circuits imprimés selon l'une quelconque des revendications précédentes, **caractérisée en ce que** le logement pour éléments (6) est fraisé dans la plaque support (1).

10. Carte de circuits imprimés selon l'une quelconque des revendications précédentes, **caractérisée en ce que** les réseaux de circuits imprimés (4) et/ou le bloc de contact (5) de l'agencement de circuits haute tension (3) sont formés par un ou par plusieurs bloc(s) de cuivre inséré dans le logement pour éléments (6).

11. Carte de circuits imprimés selon l'une quelconque des revendications précédentes, **caractérisée en ce que** les réseaux de circuits imprimés (4) et/ou le bloc de contact (5) de l'agencement de circuits haute tension (3) ont une épaisseur de 500 à 1200 µm.

12. Carte de circuits imprimés selon l'une quelconque des revendications précédentes, **caractérisée en ce que** les réseaux de circuits imprimés (4) et/ou le bloc de contact (5) de l'agencement de circuits haute tension (3) ont une épaisseur de 500 à 600 µm.

13. Carte de circuits imprimés selon l'une quelconque des revendications précédentes, **caractérisée en ce que** les réseaux de circuits imprimés (4) et/ou le bloc de contact (5) de l'agencement de circuits haute tension (3) sont collés dans le logement pour éléments (6).
